# EUROPEAN PATENT SPECIFICATION

(11) **EP 3 540 753 B1**
(45) Date of publication and mention of the grant of the patent: **09.06.2021**
(21) Application number: 17868797.6
(22) Date of filing: 17.10.2017
(51) Int. Cl.: H01H 36/00, G01V 3/08, H03K 17/955

(54) **CAPACITANCE SENSOR**
KAPAZITÄTSSENSOR
CAPTEUR CAPACITIF

(30) Priority: 14.11.2016 JP 2016221224
(43) Date of publication of application: 18.09.2019
(73) Proprietor: Alps Alpine Co., Ltd., Tokyo 1458501 (JP)
(72) Inventor: WADA Suguru, Tokyo 145-8501 (JP); YAMADA Tomoki, Tokyo 145-8501 (JP); TAKAHASHI Toru, Tokyo 145-8501 (JP)
(74) Representative: Schmitt-Nilson Schraud Waibel Wohlfrom Patentanwälte Partnerschaft mbB
(86) International application number: PCT/JP2017/037568
(87) International publication number: WO 2018/088144

(56) References cited:
- WO-A1-2010/026845
- WO-A1-2015/041268
- JP-A- 2007 329 090
- JP-A- 2015 122 188
- US-A1- 2009 135 157
- US-A1- 2012 319 994

## Description

### Technical Field

The present invention relates to a capacitive sensor, and more particularly to a capacitive sensor that is useful as an input means for a vehicle, a mobile-type electronic device, or the like.

### Background Art

As a proximity sensor that detects the proximity of a manipulating body, which is part of a human body such as a finger, there is a capacitive sensor that detects the proximity of a manipulating body on the basis of the capacitance changes of electrodes placed in a predetermined pattern.

In the capacitive sensor disclosed in PTL 1, a plurality of hollow rectangular electrodes are placed so as to have the same center. The capacitive sensor detects the presence or absence of the proximity of a manipulating body on the basis of the capacitances of the plurality of electrodes.

### Citation List

### Patent Literature

PTL 1: Japanese Unexamined Patent Application Publication No. 2010-223794
US 2012/319994 A1 discloses a coordinate detecting device which includes a detecting unit configured to detect the capacitance of each of a plurality of electrodes arranged in a predetermined direction and an arithmetic processing unit configured to calculate the coordinates of a detection target using different calculation methods according to the state of a variation in the capacitance of the plurality of electrodes.

US 2009/135157 A1 discloses a capacitive sensing input device particularly well adapted for use in electronic devices such as portable computers, PDA's, cell phones, MP3 players and the like that has reduced sensitivity to humidity and condensation.

### Summary of Invention

### Technical Problem

However, there is the problem that the conventional capacitive sensor described above can detect the presence or absence of the proximity of a manipulating body but cannot detect which direction the manipulating body is positioned.

There is also the problem that the conventional capacitive sensor described above cannot detect the proximity of a plurality of manipulating bodies with high precision.

The present invention addresses the situation with the object of providing a capacitive sensor that can highly precisely detect the direction in which a manipulating body is positioned.

Another object of the present invention is to provide a capacitive sensor that can highly precisely detect the number of manipulating bodies.

### Solution to Problem

The present invention relates to a capacitive sensor according to the appended claims.

To solve the problems with the conventional technology described above and to achieve the objects described above, a capacitive sensor in the present invention has a plurality of first electrodes that are placed on the same circumference of a circle and generate a capacitance according to a distance to a manipulating body, a capacitance detecting means that detects capacitances generated in the plurality of first electrodes, and a deciding means that decides the direction in which the manipulating body is positioned on the basis of a capacitance detected for each of the plurality of first electrodes under the condition that the sum of the capacitances detected for the plurality of first electrodes is equal to or larger than a first threshold.

According to this configuration, since a plurality of first electrodes are placed on the same circumference, when, for example, a manipulating body approaches, it is possible to have the capacitance of the corresponding first electrode meet a prescribed condition. Therefore, the direction in which the manipulating body is positioned can be identified.

Also, according to this configuration, if the condition is not met that the sum of the capacitances detected for the plurality of first electrodes is equal to or larger than the first threshold, that is, if there is the possibility that a correct decision cannot be made due to an influence such as ambient noise, a decision is not made. Therefore, a highly reliable decision can be made.

Preferably, the deciding means identifies the first electrode for which the maximum capacitance has been detected, the first electrode being one of the plurality of first electrodes. If the capacitance of the identified first electrode is equal to or larger than a second threshold, the deciding means decides that the manipulating body is positioned in the direction of the identified first electrode.

According to this configuration, if the maximum capacitance is equal to or larger than the second threshold, the deciding means decides that the manipulating body is positioned in the direction of the first electrode corresponding to it, a decision can be made under the condition that the state is such that capacitances have been correctly detected, so a highly reliable decision can be made.

Preferably, if the capacitance of the identified first electrode is smaller than the second threshold, the deciding means decides that the manipulating body is positioned in a direction perpendicular to a plane on which the plurality of first electrodes are placed.

According to this configuration, highly precise detection is possible in a case as well in which the manipulating body is positioned in the perpendicular direction.

Preferably, a second electrode is positioned at the center of the circumference enclosed by the plurality of first electrodes, a third electrode in a ring shape is provided so as to enclose the plurality of first electrodes, and the deciding means decides the number of manipulating bodies that have approached on the basis of individual capacitances detected for the plurality of first electrodes under the condition that the sum of capacitances detected for the plurality of first electrodes, the second electrode, and the third electrode is equal to or larger than the first threshold.

According to this configuration, since the total area of electrodes can be increased by providing the second electrode at the center of the circumference enclosed by the plurality of first electrodes and also providing the third electrode in a ring shape so as to enclose the plurality of first electrodes, it is possible to highly precisely detect that the manipulating body has approached and to decide the number of manipulating bodies in a state in which reliability is higher.

Preferably, the deciding means decides the number of manipulating bodies that have approached on the basis of the capacitance detected for each of the plurality of first electrodes under the condition that the sum of capacitances detected for the plurality of first electrodes is equal to or larger than a third threshold, which is larger than the first threshold.

According to this configuration, since a plurality of first electrodes are placed on the same circumference, when, for example, a plurality of manipulating bodies have approached, it is possible to have the capacitance of the first electrode meet a prescribed condition corresponding to the number of manipulating bodies. Therefore, the number of manipulating bodies can be identified.

Also, according to this configuration, if the condition is not met that the sum of the capacitances detected for the plurality of first electrodes is equal to or larger than the third threshold, that is, if there is the possibility that a correct decision cannot be made due to an influence such as ambient noise, a decision is not made. Therefore, a highly reliable decision can be made.

Preferably, the deciding means decides the number of manipulating bodies that have approached on the basis of the capacitance detected for each of the plurality of first electrodes under the condition that the sum of capacitances detected for the plurality of first electrodes, the second electrode, and the third electrode is equal to or larger than the third threshold.

According to this configuration, since the total area of electrodes can be increased by providing the second electrode at the center of the circumference enclosed by the plurality of first electrodes and also providing the third electrode in a ring shape so as to enclose the plurality of first electrodes, it is possible to highly precisely detect the number of manipulating bodies and to decide the number of manipulating bodies in a state in which reliability is higher.

Preferably, if the deciding means decides that the manipulating body is positioned only on the tops of first electrodes on the basis of the capacitances detected for the second electrode and third electrode, the deciding means performs processing to identify the number of manipulating bodies and their positions.

According to this configuration, if the manipulating body is also positioned on the top of the second electrode or third electrode other than the first electrodes, detection of the identification of the number of manipulating bodies and their positions can be selected instead of detection of the direction of the manipulating body.

Preferably, the deciding means identifies the number of first electrodes the capacitances of which are equal to or larger than a fourth threshold, the first electrodes being included in the plurality of first electrodes, and calculates the barycentric coordinate of the identified first electrodes.

According to this configuration, it is possible to highly precisely calculate the barycentric coordinate of a plurality of manipulating bodies that have approached a plurality of first electrodes.

Preferably, if the deciding means decides that the manipulating body is also positioned on the top of the second electrode or third electrode besides the first electrodes on the basis of the capacitances detected for the second electrode and third electrode, the deciding means decides that the number of manipulating bodies is 1.

According to this configuration, when the manipulating body is positioned on the top of the second electrode or third electrode besides the first electrodes, a single or a plurality of manipulating bodies can be regarded as a single manipulating body.

Preferably, if the deciding means decides that the manipulating body is also positioned on the top of the second electrode or third electrode besides the first electrodes, the deciding means identifies electrodes the capacitances of which are equal to or larger than a fifth threshold, the electrodes being included in the first electrodes, second electrode, and third electrode, and calculates a barycentric coordinate on the basis of the positions of the identified electrodes.

According to this configuration, a barycentric coordinate according to the posture of one manipulating body can be calculated.

Preferably, if the sum is smaller than the third threshold, the deciding means decides the direction in which the manipulating body is positioned on the basis of the capacitance detected for each of the plurality of first electrodes.

According to this configuration, if a manipulating body is too distant to precisely detect the number of manipulating bodies but is positioned within a distance that is short enough to detect the direction of the manipulating body, the direction of the manipulating body is decided. Therefore, it is possible to highly precisely detect the direction of the manipulating body and to reduce the possibility that the number of manipulating bodies is incorrectly decided.

Preferably, the plurality of first electrodes have the same shape and are placed in a circumferential direction at equal intervals.

Preferably, the deciding means decides the motion of the manipulating body on the basis of time-dependent changes in the capacitance detected for each of the plurality of first electrodes.

According to this configuration, it is possible to decide the motion of the manipulating body that, for example, has approached.

### Advantageous Effects of Invention

According to the present invention, it is possible to provide a capacitive sensor that can highly precisely detect the direction in which a manipulating body is positioned.

Also, the present invention can provide a capacitive sensor that can highly precisely detect the number of manipulating bodies.

### Brief Description of Drawings

[Fig. 1] Fig. 1 is a planar structural diagram of a capacitive sensor according to an embodiment of the present invention.
[Fig. 2] Fig. 2 is the configuration of the capacitive sensor indicated in Fig. 1 on a cross section.
[Fig. 3] Fig. 3 is a drawing indicating a case in which one manipulating body is present in Fig. 1.
[Fig. 4] Fig. 4 is a cross-sectional structural diagram of the capacitive sensor in a case in which two manipulating bodies are present.
[Fig. 5] Fig. 5 is a planar structural diagram in the case of Fig. 4.
[Fig. 6] Fig. 6 is a drawing used to explain the motion of the two manipulating bodies.
[Fig. 7] Fig. 7 is a flowchart used to explain an example of the whole operation of the capacitive sensor indicated in Fig. 1 and Fig. 2.
[Fig. 8] Fig. 8 is a flowchart used to explain processing performed during a contact decision in step ST4 indicated in Fig. 7.
[Fig. 9] Fig. 9 is a flowchart used to explain a method of deciding whether or not the manipulating body in step ST41 indicated in Fig. 8 is present only on first electrodes.
[Fig. 10] Fig. 10 is a flowchart used to explain a method of identifying the number of manipulating bodies on first electrodes and the coordinates of the manipulating bodies in step ST43 indicated in Fig. 8.
[Fig. 11] Fig. 11 is a drawing used to explain the coordinate of the manipulating body, the coordinate being calculated in step ST436 in Fig. 10.
[Fig. 12] Fig. 12 is a drawing used to explain the direction in which the manipulating body approaches, the direction being calculated in step ST5 in Fig. 7.
[Fig. 13] Fig. 13A is a conceptual diagram in which a manipulating body is positioned apart from the top of one first electrode in the capacitive sensor indicated in Fig. 1 and Fig. 2. Fig. 13B is an example, in this case, of the capacitances of the first electrodes, second electrode, and third electrode as well as the sum SUM of these capacitances.
[Fig. 14] Fig. 14A is a conceptual diagram in which three manipulating bodies are positioned apart from the tops of first electrodes when the manipulating bodies have come into contact with the capacitive sensor indicated in Fig. 1 and Fig. 2. Fig. 14B is an example, in this case, of the capacitances of the first electrodes, second electrode, and third electrode as well as the sum SUM of these capacitances.
[Fig. 15] Fig. 15 is a diagram indicating a flow in which, in step ST436 in Fig. 10, the number of manipulating bodies and their coordinates are calculated from the capacitances indicated in Fig. 14.
[Fig. 16] Fig. 16A is a conceptual diagram in which one manipulating body is positioned apart from the tops of first electrodes when the manipulating body has widely come into contact with the capacitive sensor indicated in Fig. 1 and Fig. 2. Fig. 16B is an example, in this case, of the capacitances of the first electrodes, second electrode, and third electrode as well as the sum SUM of these capacitances.
[Fig. 17] Fig. 17 is a planar structural diagram of a capacitive sensor composed of only the first electrodes and second electrode, according to an embodiment of the present invention.
[Fig. 18] Fig. 18 is a planar structural diagram of a capacitive sensor composed of only the first electrodes and third electrode, according to an embodiment of the present invention.
[Fig. 19] Fig. 19 is a planar structural diagram of a capacitive sensor in which the third electrode is not in a complete ring shape, according to an embodiment of the present invention.

### Description of Embodiments

A capacitive sensor according to embodiments of the present invention will be described below.

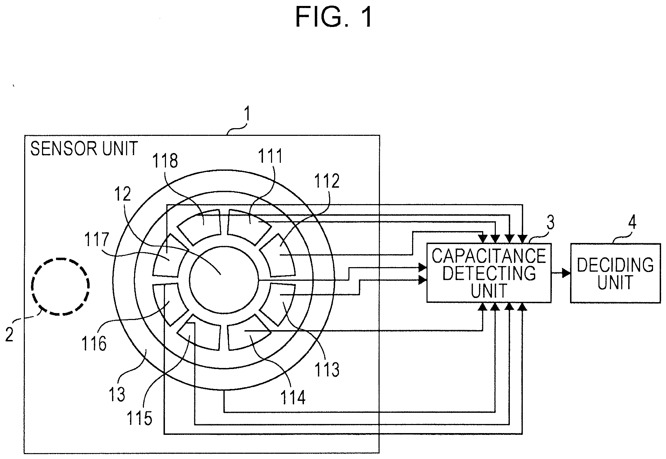

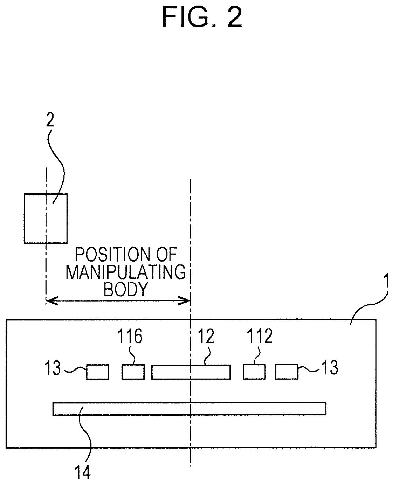

Fig. 1 is a planar structural diagram of a capacitive sensor according to an embodiment of the present invention. Fig. 2 is the configuration of a sensor part 1, on a cross section, in the capacitive sensor indicated in Fig. 1.

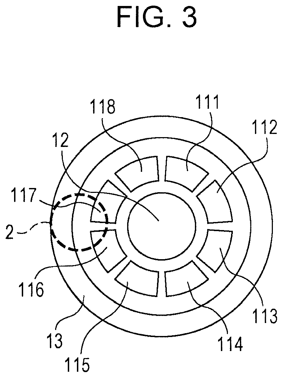

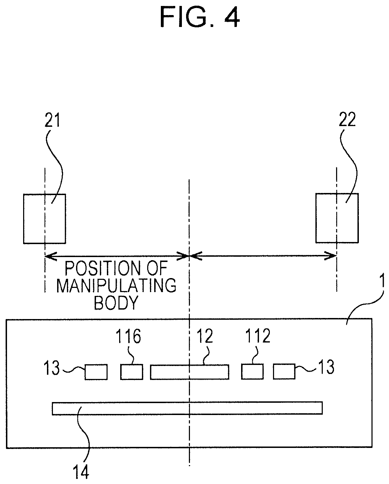

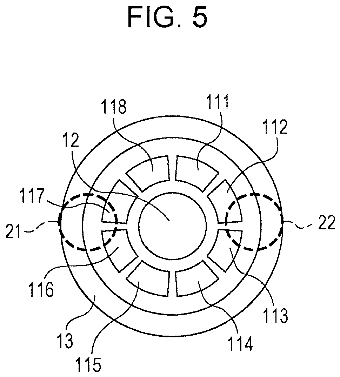

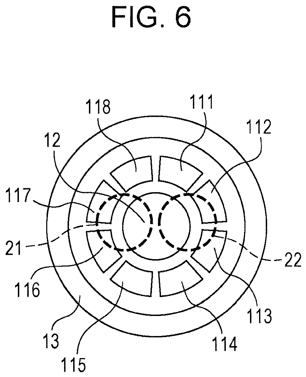

Fig. 3 is a drawing indicating a case in which one manipulating body 2 is present in Fig. 1. Fig. 4 is a cross-sectional structural diagram of the capacitive sensor in a case in which two manipulating bodies, 21 and 22, are present. Fig. 5 is a planar structural diagram in the case of Fig. 4. Fig. 6 is a drawing used to explain the motion of the two manipulating bodies, 21 and 22.

As indicated in Fig. 1, a sensor unit 1 in the capacitive sensor has first electrodes 111, 112, 113, 114, 115, 116, 117, and 118, a second electrode 12, and a third electrode 13, which are disposed at places where the manipulating body 2, which is part of a human body such as a finger, is detected. These electrodes are provided on, for example, the same plane.

Also, the capacitive sensor has a capacitance detecting unit 3 and a deciding unit 4.

As indicated in Fig. 1, the second electrode 12 has a discoid shape. The first electrodes 111, 112, 113, 114, 115, 116, 117, and 118, each of which is of a fan type and has the same shape and the same size, are provided at equal angular intervals around the second electrode 12 so as to enclose the second electrode 12.

The third electrode 13, which is in a ring shape and encloses the second electrode 12, is provided outside the first electrodes 111, 112, 113, 114, 115, 116, 117, and 118.

As indicated in Fig. 2, a shield electrode 14 is formed on a substrate on a rear surface opposite to a manipulation surface (not indicated on the drawing) for the first electrodes 111, 112, 113, 114, 115, 116, 117, and 118, the second electrode 12, and the third electrode 13.

In the capacitive sensor, when the grounded manipulating body 2 approaches the first electrode 111, 112, 113, 114, 115, 116, 117 or 118, the second electrode 12, or the third electrode 13, a capacitor under measurement is formed between the relevant electrode and the manipulating body 2. The capacitive sensor detects the proximity of the manipulating body 2 by detecting the capacitance of the capacitor under measurement. Between the manipulating body 2 and the first electrode 111, 112, 113, 114, 115, 116, 117 or 118, the second electrode 12, or the third electrode 13, a capacitance according to the distance between them is generated.

The capacitance detecting unit 3 detects a capacitance between the ground (manipulating body 2) and each of the first electrodes 111, 112, 113, 114, 115, 116, 117, and 118, the second electrode 12, and the third electrode 13 in a self-capacitance method.

The capacitance detecting unit 3 applies a pulse voltage, which is a predetermined voltage, to an electrode to be detected, which is one of the first electrodes 111, 112, 113, 114, 115, 116, 117, and 118, the second electrode 12, and the third electrode 13, so that charge is accumulated in the capacitor under measurement, which is formed between the manipulating body 2 and the electrode to be detected. Then, the capacitance detecting unit 3 supplies the accumulated charge to a capacitor for measurement and detects the capacitance of the capacitor under measurement, that is, the electrode to be detected by measuring the voltage of the capacitor for measurement.

The capacitance detecting unit 3 outputs capacitances detected for the first electrodes 111, 112, 113, 114, 115, 116, 117, and 118, the second electrode 12, and the third electrode 13 to the deciding unit 4.

In this embodiment, the capacitances of the first electrodes 111, 112, 113, 114, 115, 116, 117, and 118, the second electrode 12, and the third electrode 13 will be respectively denoted CA111, CA112, CA113, CA114, CA115, CA116, CA117, CA118, CA12, and CA13.

The deciding unit 4 decides the number of manipulating bodies 2 or the like and directions in which the manipulating bodies 2 or the like are positioned, on the basis of the capacitances entered from the capacitance detecting unit 3.

The deciding unit 4 calculates the sum SUM of the capacitances CA111, CA112, CA113, CA114, CA115, CA116, CA117, CA118, CA12, and CA13.

Under the condition that the sum SUM is equal to or greater than a third threshold TH3 (> TH1), the deciding unit 4 performs decision processing for the number of manipulating bodies 2 close to (or in contact with) the capacitive sensor and their coordinates.

Through decision processing as to whether or not the manipulating body 2 described above is present only on first electrodes, if the deciding unit 4 decides that the manipulating body 2 is present only on the first electrodes, the deciding unit 4 performs count and coordinate identification processing for the number of manipulating bodies present on the first electrodes and the coordinates of the manipulating bodies.

In the count and coordinate identification processing, the deciding unit 4 identifies a group of consecutive first electrodes for which a capacitance value exceeding a sixth threshold has been detected, the capacitance value being any one of the capacitances CA111, CA112, CA113, CA114, CA115, CA116, CA117, and CA118, for example, after which the deciding unit 4 calculates the number of manipulating bodies from the count of the identified first electrode group and also calculates the coordinates of the manipulating bodies from the barycenter of the capacitance values of the identified first electrode group.

Through the decision processing as to whether or not the manipulating body 2 described above is present only on first electrodes, if the deciding unit 4 decides that the manipulating body 2 is also present on other than the first electrodes, the deciding unit 4 regards a single or a plurality of manipulating bodies 2 as a single manipulating body and identifies the barycenter of the manipulating body 2 or the like.

For example, the deciding unit 4 identifies a barycentric point on the basis of the capacitances CA111, CA112, CA113, CA114, CA115, CA116, CA117, CA118, CA12, and CA13 as well as the positions of the first electrodes 111, 112, 113, 114, 115, 116, 117, and 118, the second electrode 12, and the third electrode 13. Specifically, the deciding unit 4 obtains the barycenter by giving each position a capacitance corresponding to it as weighting.

If the capacitance CA12 of the second electrode 12 is equal to or larger than the sixth threshold TH6, the deciding unit 4 decides that the manipulating body 2 is also present on other than the first electrodes.

If the capacitance CA13 of the second electrode 13 is equal to or larger than a seventh threshold TH7, the deciding unit 4 decides that the manipulating body 2 is also present on other than the first electrodes.

If the capacitance CA12 of the second electrode 12 is smaller than the sixth threshold TH6 and the capacitance CA13 of the third electrode 13 is smaller than the seventh threshold TH7, the deciding unit 4 decides that the manipulating body 2 is present only on first electrodes.

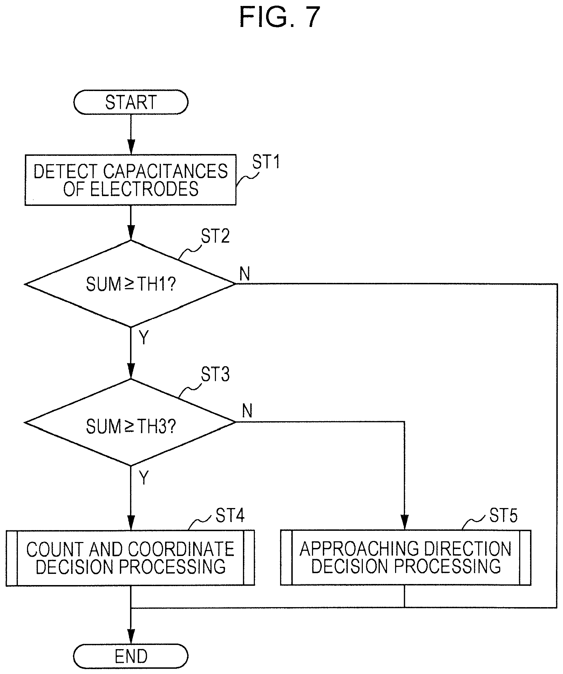

Under the condition that the sum SUM is equal to or larger than a first threshold TH1 (< TH3), the deciding unit 4 decides the direction in which the manipulating body 2 is positioned on the basis of the capacitances CA111, CA112, CA113, CA114, CA115, CA116, CA117, and CA118, as indicated in Fig. 7.

The deciding unit 4 identifies the first electrode 111, 112, 113, 114, 115, 116, 117, or 118 that has the maximum capacitance among the capacitances CA111, CA112, CA113, CA114, CA115, CA116, CA117, and CA118.

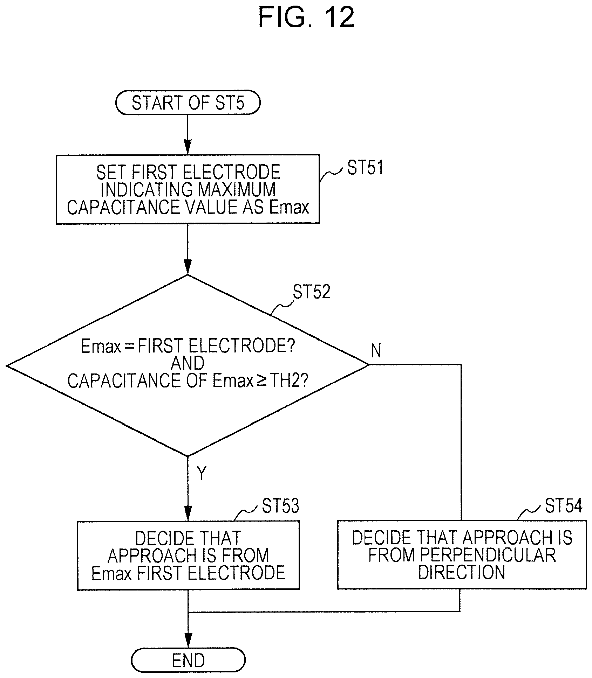

Then, if the capacitance of the identified first electrode is equal to or larger than a second threshold TH2, the deciding unit 4 decides that the manipulating body 2 is positioned in the direction of the identified first electrode, as indicated in Fig. 12.

The deciding unit 4 decides the motion of the manipulating body 2 on the basis of time-dependent changes in the capacitances CA111, CA112, CA113, CA114, CA115, CA116, CA117, and CA118. When, for example, two manipulating bodies 21 and 22 are detected, the deciding unit 4 decides motion from their positions indicated in Fig. 5 to their positions indicated in Fig. 6.

An example of the operation of the capacitive sensor indicated in Fig. 1 and Fig. 2 will be described below.

Fig. 7 is a flowchart used to explain an example of the whole operation of the capacitive sensor indicated in Fig. 1 and Fig. 2.

The capacitive sensor performs processing indicated in Fig. 7 at a constant period.

### Step ST1:

The capacitance detecting unit 3 detects the capacitances CA111, CA112, CA113, CA114, CA115, CA116, CA117, CA118, CA12, and CA13 for the respective first electrodes 111, 112, 113, 114, 115, 116, 117, and 118, the second electrode 12, and the third electrode 13.

The capacitance detecting unit 3 outputs the detected capacitances CA111, CA112, CA113, CA114, CA115, CA116, CA117, CA118, CA12, and CA13 to the deciding unit 4.

### Step ST2:

The deciding unit 4 calculates the sum SUM of the capacitances CA111, CA112, CA113, CA114, CA115, CA116, CA117, CA118, CA12, and CA13 entered in step ST1.

The deciding unit 4 decides whether or not the sum SUM is equal to or larger than the first threshold TH1. If the decision is affirmative, the deciding unit 4 proceeds to step ST3. If the decision is negative, the deciding unit 4 terminates the processing. Here, the first threshold TH1 has been set to a value with which approaching direction decision processing in step ST5 can be performed with certain reliability.

### Step ST3:

The deciding unit 4 decides whether or not the sum SUM is equal to or larger than the third threshold TH3. If the decision is affirmative, the deciding unit 4 proceeds to step ST4. If the decision is negative, the deciding unit 4 proceeds to step ST5.

### Step ST4:

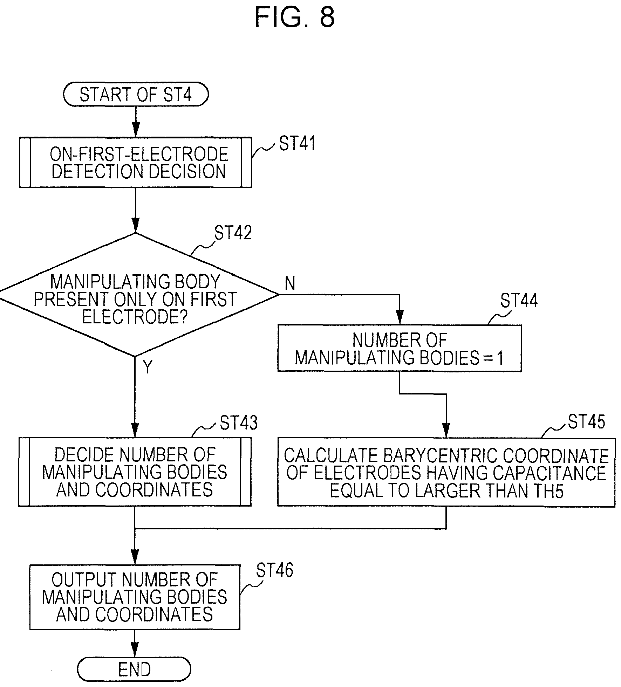

The deciding unit 4 decides the number of manipulating bodies 2 and their coordinates. Processing to decide the number of manipulating bodies 2 and their coordinates will be described in detail by using Fig. 8.

### Step ST5:

The deciding unit 4 decides the direction of the manipulating body 2. Processing to decide the direction will be described in detail by using Fig. 12.

A method of deciding the number of manipulating bodies 2 or the like and their coordinates will be described below, the method being in step ST4 indicated in Fig. 8.

Fig. 8 is a flowchart used to explain the method of deciding the number and the coordinates in step ST4 indicated in Fig. 7.

### Step ST41:

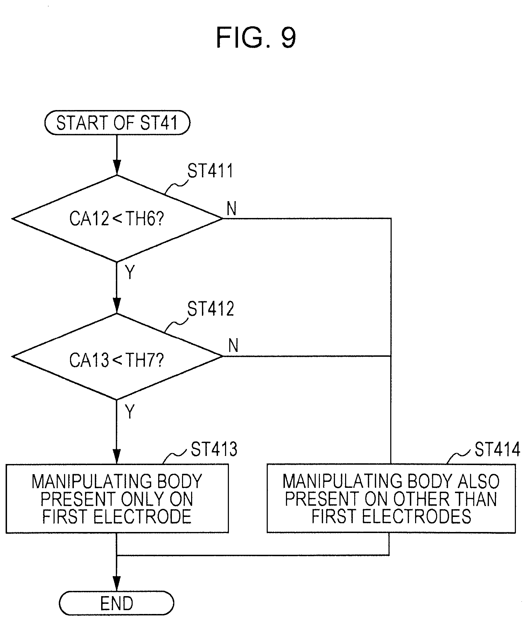

The deciding unit 4 decides whether or not manipulating body 2 or the like is present only on first electrodes. The deciding processing will be described in detail by using Fig. 9.

### Step ST42:

If the deciding unit 4 decides in step ST41 that the manipulating body 2 or the like is present only on first electrodes, the deciding unit 4 processes to step ST43. If not, the deciding unit 4 proceeds to step ST44.

### Step ST43:

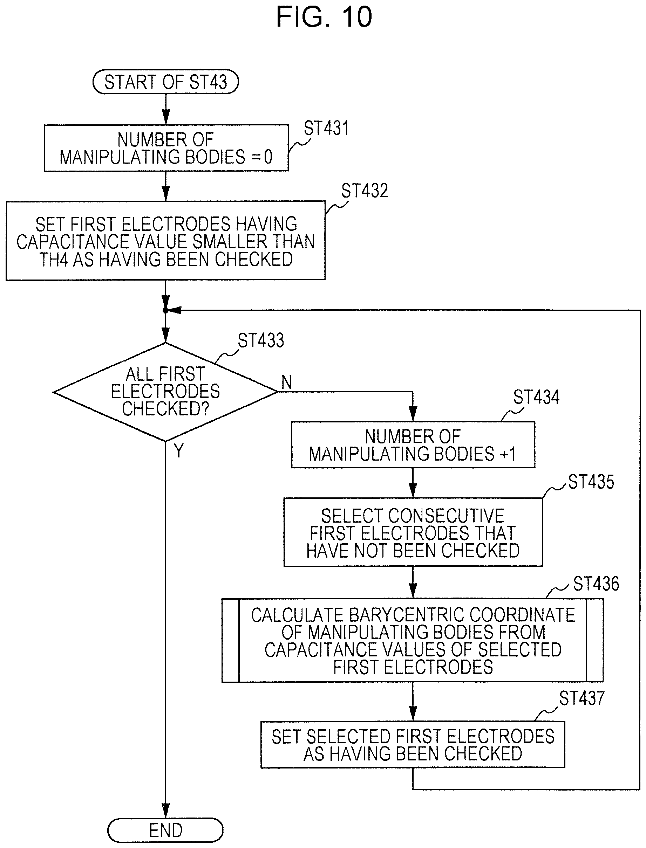

The deciding unit 4 decides the number of manipulating bodies 2 present on the first electrodes and the coordinates of the manipulating bodies 2. The deciding processing will be described in detail by using Fig. 10.

### Step ST44:

The deciding unit 4 decides that the number of manipulating bodies 2 is 1.

### Step ST45:

The deciding unit 4 identifies the barycenter of a single or a plurality of manipulating bodies 2 or the like.

For example, the deciding unit 4 identifies a barycentric point on the basis of the capacitances CA111, CA112, CA113, CA114, CA115, CA116, CA117, CA118, CA12, and CA13 as well as the positions of the first electrodes 111, 112, 113, 114, 115, 116, 117, and 118, the second electrode 12, and the third electrode 13.

Specifically, the deciding unit 4 identifies electrodes the capacitances of which are equal to or larger than a fifth threshold TH5, the electrodes being included in the first electrodes 111 to 118, second electrode 12, and third electrode 13, and calculates a barycentric coordinate on the basis of the positions of the identified electrodes.

### Step ST46:

The deciding unit 4 outputs the decided number of manipulating bodies 2 and their coordinates.

A method of deciding whether or not the manipulating body 2 or the like is present only on first electrodes will be described below, the method being in step ST41 indicated in Fig. 9.

Fig. 9 is a flowchart used to explain the on-first-electrodes detection decision method in step ST41 indicated in Fig. 8.

### Step ST411:

The deciding unit 4 decides whether or not the capacitance value CA12 of the second electrode 12 is smaller than the sixth threshold TH6. If the decision is affirmative, the deciding unit 4 proceeds to step ST412. If the decision is negative, the deciding unit 4 proceeds to step ST414.

### Step ST412:

The deciding unit 4 decides whether or not the capacitance value CA13 of the third electrode 13 is smaller than the seventh threshold TH7. If the decision is affirmative, the deciding unit 4 proceeds to step ST413. If the decision is negative, the deciding unit 4 proceeds to step ST414.

### Step ST413:

The deciding unit 4 decides that the manipulating body 2 or the like is present only on first electrodes.

### Step ST414:

The deciding unit 4 decides that the manipulating body 2 or the like is also present on other than the first electrodes.

A method of deciding the number of manipulating bodies 2 present on first electrodes and the coordinates of the manipulating bodies 2 will be described below, the method being in step ST43 indicated in Fig. 10.

Fig. 10 is a flowchart used to explain the method of deciding the number of manipulating bodies and their coordinates, the method being in step ST43 indicated in Fig. 8.

### Step ST431:

The deciding unit 4 initializes the number of manipulating bodies to 0.

### Step ST432:

The deciding unit 4 decides that the first electrodes 111, 112, 113, 114, 115, 116, 117, and 118 for which the capacitances CA111, CA112, CA113, CA114, CA115, CA116, CA117, and CA118 are smaller than a fourth threshold TH4 have been already checked.

### Step ST433:

The deciding unit 4 scans the first electrodes 111, 112, 113, 114, 115, 116, 117, and 118, and decides whether or not all of these electrodes have been checked. If the decision is affirmative, the deciding unit 4 terminates the processing. If the decision is negative, the deciding unit 4 proceeds to step ST434.

### Step ST434:

The deciding unit 4 increments the number of manipulating bodies by one.

### Step ST435:

The deciding unit 4 selects one or more consecutive first electrodes that have not been checked and are enclosed by checked electrodes included in the first electrodes 111, 112, 113, 114, 115, 116, 117, and 118.

### Step ST436:

The deciding unit 4 calculates the barycentric coordinate of the first electrodes the number of which has been increased in step ST434 from the capacitance values of the first electrodes selected in step ST435, as the barycentric coordinate of the manipulating bodies.

### Step ST437:

The deciding unit 4 sets the first electrodes selected in step ST435 as having been checked.

The method, indicated in step ST5 in Fig. 12, of deciding the direction in which the manipulating body 2 approaches will be described below.

Fig. 12 is a flowchart used to explain the approaching direction decision method in step ST5 indicated in Fig. 7.

### ST51:

The deciding unit 4 stores the electrode that indicates the maximum value out of the capacitances CA111, CA112, CA113, CA114, CA115, CA116, CA117, CA118, CA12, and CA13 as Emax.

### Step ST52:

The deciding unit 4 decides whether or not Emax is a first electrode and the capacitance value of Emax is equal to or larger than second threshold TH2. If the decision is affirmative, the deciding unit 4 proceeds to step ST53. If the decision is negative, the deciding unit 4 proceeds to step ST54.

### Step ST53:

The deciding unit 4 decides that the manipulating body 2 is present in the direction of the first electrode that is Emax.

### Step ST54:

The deciding unit 4 decides that the manipulating body 2 is present in a direction perpendicular to the capacitive sensor 1.

As described above, according to the capacitive sensor, since a plurality of first electrodes, 111, 112, 113, 114, 115, 116, 117, and 118, are placed on the same circumference as indicated in Fig. 1, when, for example, a plurality of manipulating bodies 21 and 22 approach the tops of first electrodes, it is possible to have the capacitances of the corresponding first electrodes meet a prescribed condition. Therefore, the number of manipulating bodies 2 and their coordinates can be identified.

Also, according to this configuration, if the condition is not met that the sum of the capacitances CA111, CA112, CA113, CA114, CA115, CA116, CA117, CA118, CA12, and CA13 is equal to or larger than the first threshold TH1 as indicated in step ST2 indicated in Fig. 7, that is, if there is the possibility that a correct decision cannot be made due to an influence such as ambient noise, a decision is not made. Therefore, a highly reliable decision can be made.

Also, according to the capacitive sensor, if the capacitance of the maximum electrode Emax is equal to or larger than the second threshold TH2 as indicated in steps ST52 and ST53 in Fig. 12, it is decided that the manipulating body is positioned in the direction of the first electrode 111, 112, 113, 114, 115, 116, 117, or 118 corresponding to that. Therefore, a decision can be made under the condition that the state is such that capacitances have been correctly detected, so a highly reliable decision can be made.

Also, in the capacitive sensor, processing to identify the number of manipulating bodies is performed under the condition that the sum SUM of the capacitances CA111, CA112, CA113, CA114, CA115, CA116, CA117, CA118, CA12, and CA13 is equal to or larger than the third threshold TH3, as indicated in steps ST3 and ST4 indicated in Fig. 7. That is, if there is the possibility that a correct decision cannot be made due to an influence such as ambient noise, a decision is not made. Therefore, a highly reliable decision can be made.

Also, according to the capacitive sensor, a decision can be made on the number of manipulating bodies 2 and their coordinates as indicated in step ST4 in Fig. 7.

Also, according to the capacitive sensor, since the total area of electrodes can be increased by providing the third electrode 13 in a ring shape so as to enclose the first electrodes 111, 112, 113, 114, 115, 116, 117, and 118, the proximity of the manipulating bodies 2 can be highly precisely detected and the number of manipulating bodies can be decided in a state in which reliability is higher.

Also, according to the capacitive sensor, whether or not the manipulating body is about to come into contact with only first electrodes can be highly precisely decided by deciding whether or not the manipulating body 2 is present only on first electrodes as indicated in step ST41 in Fig. 8.

Also, according to the capacitive sensor, a complex decision can be achieved from the number of manipulating bodies 2 present on first electrodes and the coordinates of the manipulating bodies 2 by deciding the number of manipulating bodies 2 present on first electrodes and the coordinates of the manipulating bodies 2 as indicated in step ST43 in Fig. 8.

Specific examples of the operation of the capacitive sensor described above will be described below.

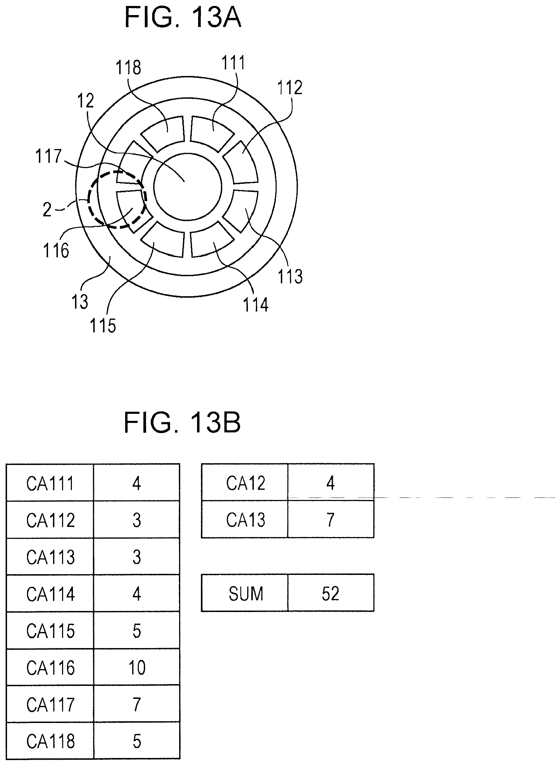

In a case in which the manipulating body 2 is positioned apart from the top of the first electrode 116 as indicated in Fig. 13A and the capacitances CA111, CA112, CA113, CA114, CA115, CA116, CA117, CA118, CA12, and CA13 as indicated in Fig. 13B are obtained, how the flowchart indicated in Fig. 7 is processed will be described.

Fig. 13A is a conceptual diagram in which the manipulating body 2 is positioned apart from the top of the first electrode 116. Fig. 13B is an example, in this case, of the capacitances CA111, CA112, CA113, CA114, CA115, CA116, CA117, CA118, CA12, and CA13 as well as the sum SUM of these capacitances.

Through step ST1 in the flowchart in Fig. 7, the capacitances CA111, CA112, CA113, CA114, CA115, CA116, CA117, CA118, CA12, and CA13 indicated in Fig. 13B are obtained from the capacitance detecting unit 3. The sequence proceeds to step ST2.

Through step ST2 in the flowchart in Fig. 7, the sum SUM (= 52) of the capacitances CA111, CA112, CA113, CA114, CA115, CA116, CA117, CA118, CA12, and CA13 indicated in Fig. 13B is calculated and is compared with TH1.

If TH1 = 50, the decision in step ST2 is affirmative and the sequence proceeds to step ST3.

Through step ST3 in the flowchart in Fig. 7, the capacitance SUM (= 52) indicated in Fig. 13B is compared with TH3.

If TH3 = 200, the decision in step ST2 is negative and the sequence proceeds to step ST5 and step ST51 in Fig. 12.

Through step ST51 in the flowchart in Fig. 12, the electrode Emax indicating the maximum value is retrieved from among the capacitances CA111, CA112, CA113, CA114, CA115, CA116, CA117, CA118, CA12, and CA13 indicated in Fig. 13B.

Since CA116 is maximum (10), the electrode 116 is assumed to be the Emax and the sequence proceeds to step ST52.

Through step ST52 in the flowchart in Fig. 12, it is decided whether or not the Emax is a first electrode and has a capacitance equal to or larger than the second threshold TH2.

If TH2 = 5, as the electrode 116 is a first electrode and CA116 is larger than TH2, the sequence proceeds to step ST53.

Through step ST53 in the flowchart in Fig. 12, it is decided that the manipulating body 2 is in the direction of Emax.

Since Emax is the electrode 116, it is decided that the manipulating body 2 is present in the direction of the electrode 116. The whole of the flow is terminated.

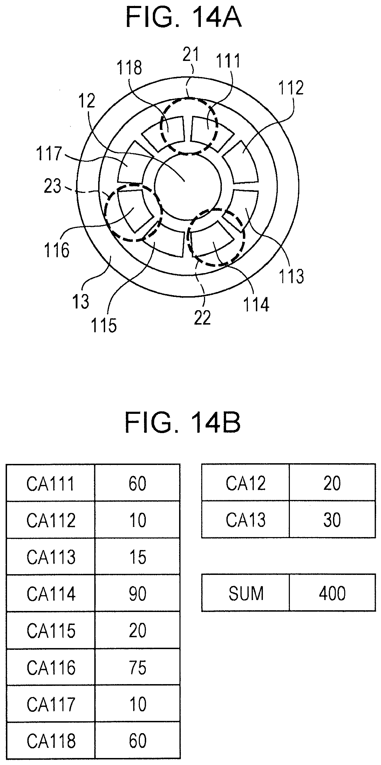

In a case in which manipulating bodies 21, 22, and 23 come into contact with the tops of first electrodes as indicated in Fig. 14A and the capacitances CA111, CA112, CA113, CA114, CA115, CA116, CA117, CA118, CA12, and CA13 as indicated in Fig. 14B are obtained, how the flowchart indicated in Fig. 7 is processed will be described below.

Fig. 14A is a conceptual diagram in which the manipulating bodies 21, 22, and 23 are positioned on the tops of first electrodes. Fig. 14B is an example, in this case, of the capacitances CA111, CA112, CA113, CA114, CA115, CA116, CA117, CA118, CA12, and CA13 as well as the sum SUM of these capacitances.

Through step ST1 in the flowchart in Fig. 7, the capacitances CA111, CA112, CA113, CA114, CA115, CA116, CA117, CA118, CA12, and CA13 indicated in Fig. 14B are obtained from the capacitance detecting unit 3. The sequence proceeds to step ST2.

Through step ST2 in the flowchart in Fig. 7, the sum SUM (= 400) of the capacitances CA111, CA112, CA113, CA114, CA115, CA116, CA117, CA118, CA12, and CA13 indicated in Fig. 14B is calculated and is compared with TH1.

If TH1 = 50, the decision in step ST2 is affirmative and the sequence proceeds to step ST3.

Through step ST3 in the flowchart in Fig. 7, the capacitance SUM (= 400) indicated in Fig. 13B is compared with TH3.

If TH3 = 200, the decision in step ST2 is affirmative and the sequence proceeds to step ST4, step ST41 in Fig. 8, and step 411 in Fig. 9.

Through step ST411 in the flowchart in Fig. 9, the capacitance CA12 (= 20) indicated in Fig. 13B is compared with TH6.

If TH6 = 50, the decision in step ST411 is affirmative and the sequence proceeds to step ST412.

Through step ST412 in the flowchart in Fig. 9, the capacitance CA13 (= 30) indicated in Fig. 13B is compared with TH7.

If TH7 = 50, the decision in step ST412 is affirmative and the sequence proceeds to step ST413.

Through step ST413 in the flowchart in Fig. 9, it is decided that the manipulating body 2 is present only on first electrodes and the sequence proceeds to step ST42 in Fig. 8.

Through step ST42 in the flowchart in Fig. 8, it is decided whether or not the manipulating body 2 is present only on first electrodes.

Since it has been decided through step 413 that the manipulating body 2 is present only on first electrodes, the decision in step ST42 is affirmative and the sequence proceeds to step ST43 and step 431 in Fig. 10.

Through step ST431 in the flowchart in Fig. 10, the number of manipulating bodies 2 is initialized to 0. The sequence proceeds to step ST432.

Through step ST432 in the flowchart in Fig. 10, first electrodes having a capacitance smaller than the fourth threshold TH4 are set as having been checked.

If TH4 = 50, the first electrodes 112, 113, 115, and 117 are set as having been checked and the sequence proceeds to step ST433.

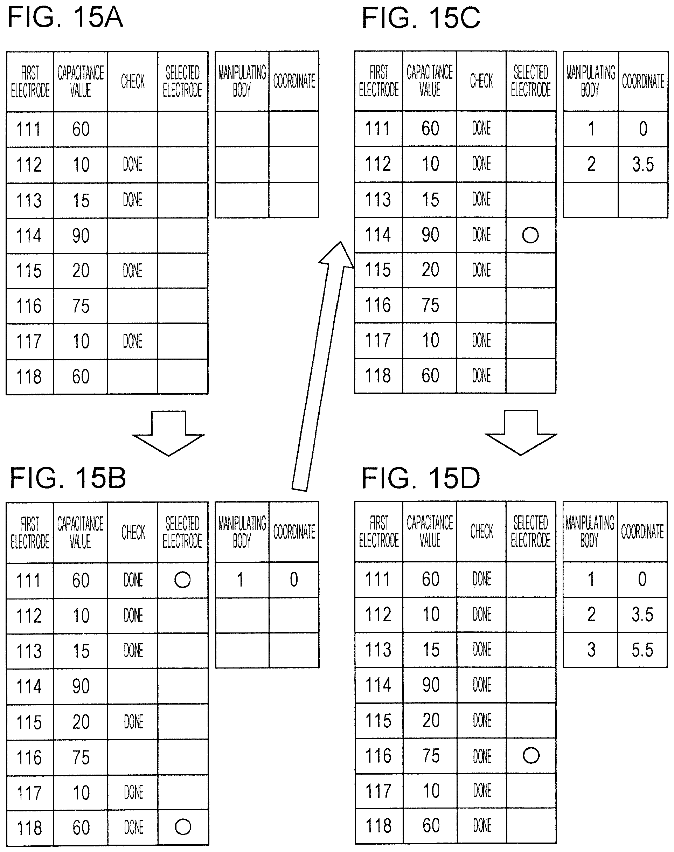

Fig. 15A is a data state in the deciding unit 4 at that time.

Through step ST433 in the flowchart in Fig. 10, the check state of the first electrodes is confirmed. Since all first electrodes have not been checked as indicated in Fig. 15A, the decision in step ST433 is negative and the sequence proceeds to step 434.

Through step ST434 in the flowchart in Fig. 10, the number of manipulating bodies is incremented by one and is changed from 0 to 1. The sequence proceeds to step 435.

Through step ST435 in the flowchart in Fig. 10, consecutive electrodes that have not been checked are selected from among the first electrodes. In the case in this time, as the first electrode 111 and the first electrode 118 adjacent to it have not been checked, the first electrodes 111 and 118 are selected. Although the first electrode 114 and first electrode 116 also have not been checked, as they are not consecutive to the first electrode 111 or 118, they are not selected. The sequence proceeds to step ST436.

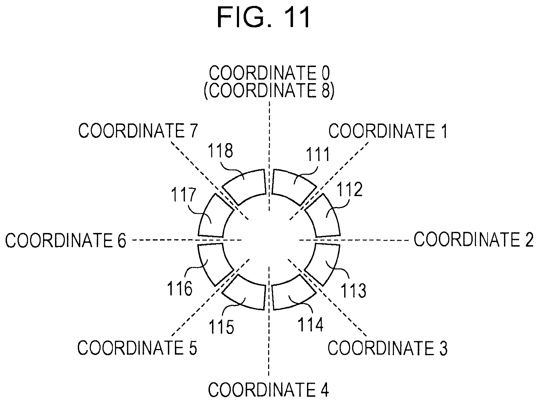

Through step ST436 in the flowchart in Fig. 10, the barycentric coordinate of the first manipulating body 21 is calculated from the capacitances of the selected first electrodes 111 and 118. As shown in Fig. 11, the barycentric coordinate described here is a coordinate equivalent to an angular coordinate from the center taken when the coordinate between the first electrodes 111 and 118 is 0, the first electrode 111 is 0.5, the coordinate between the first electrodes 111 and 112 is 1, and so on. The barycenter of the capacitance values CA111 and CA118 of the selected first electrodes 111 and 118 are just the center of the first electrodes 111 and 118. Therefore, the coordinate is calculated to be 0. The sequence proceeds to step 437.

Through step ST437 in the flowchart in Fig. 10, the selected first electrodes 111 and 118 are set as having been checked and the sequence proceeds to step ST433.

Fig. 15B is a data state in the deciding unit 4 at that time.

Through steps ST433 to 437 in the flowchart in Fig. 10, the unchecked first electrode 114 is selected, the number of manipulating bodies is incremented, the coordinate is calculated to be 3.5, the first electrode 114 is set as having been checked, and the sequence proceeds to step ST433.

Fig. 15C is a data state in the deciding unit 4 at that time.

Through steps ST433 to 437 in the flowchart in Fig. 10, the unchecked first electrode 116 is selected, the number of manipulating bodies is incremented, the coordinate is calculated to be 5.5, the first electrode 116 is set as having been checked, and the sequence proceeds to step ST433.

Fig. 15D is a data state in the deciding unit 4 at that time.

Through step ST433 in the flowchart in Fig. 10, the check state of the first electrodes is confirmed. Since all first electrodes have been checked as indicated in Fig. 15D, the decision in step ST433 is affirmative, step ST43 is terminated, and the sequence proceeds to step ST46 in Fig. 8.

Through step ST46 in the flowchart in Fig. 10, the calculated number (= 3) of manipulating bodies, 21, 22 and 23, and coordinates (0, 3.5, and 5.5) are output. Step ST4 in the flowchart in Fig. 7 and the entire flow are terminated.

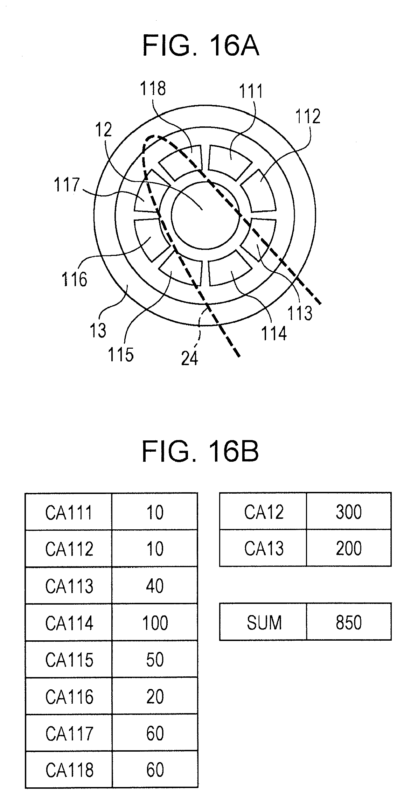

In a case in which a manipulating body 24 comes into contact with the tops of first electrodes, the top of the second electrode, and the top of the third electrode so as to span these tops as indicated in Fig. 16A and the capacitances CA111, CA112, CA113, CA114, CA115, CA116, CA117, CA118, CA12, and CA13 as indicated in Fig. 16B are obtained, how the flowchart indicated in Fig. 7 is processed will be described below.

Fig. 16A is a conceptual diagram in which the manipulating body 24 is in contact with the tops of first electrodes, the top of the second electrode, and the top of the third electrode. Fig. 16B is an example, in this case, of the capacitances of the capacitances CA111, CA112, CA113, CA114, CA115, CA116, CA117, CA118, CA12, and CA13 as well as the sum SUM of these capacitances.

Through step ST1 in the flowchart in Fig. 7, the capacitances CA111, CA112, CA113, CA114, CA115, CA116, CA117, CA118, CA12, and CA13 indicated in Fig. 14 are obtained from the capacitance detecting unit 3. The sequence proceeds to step ST2.

Through step ST2 in the flowchart in Fig. 7, the sum SUM (= 850) of the capacitances CA111, CA112, CA113, CA114, CA115, CA116, CA117, CA118, CA12, and CA13 indicated in Fig. 14 is calculated and is compared with TH1.

If TH1 = 50, the decision in step ST2 is affirmative and the sequence proceeds to step ST3.

Through step ST3 in the flowchart in Fig. 7, the capacitance SUM (= 850) indicated in Fig. 13B is compared with TH3.

If TH3 = 200, the decision in step ST2 is affirmative and the sequence proceeds to step ST4, step ST41 in Fig. 8, and step ST411 in Fig. 9.

Through step ST411 in the flowchart in Fig. 9, the capacitance CA12 (= 300) indicated in Fig. 13B is compared with TH6.

If TH6 = 50, the decision in step ST411 is negative and the sequence proceeds to step ST414.

Through step ST414 in the flowchart in Fig. 9, it is decided that the first electrode 24 is also present on the tops of other than the first electrodes. Step ST41 is terminated and the sequence proceeds to step ST42 in Fig. 8.

Through step ST42 in the flowchart in Fig. 8, it is decided whether or not the manipulating body 24 is present only on first electrodes.

Since it has been decided through step ST414 that the manipulating body 24 is also present on other than the first electrodes, the decision in step ST42 is negative and the sequence proceeds to step ST44.

Through step ST44 in the flowchart in Fig. 8, it is decided that the number of manipulating bodies 24 is 1. The sequence proceeds to step ST45.

Through step ST45 in the flowchart in Fig. 8, the barycentric coordinate of the manipulating body 24 is calculated. The result, described here, of the barycentric coordinate is output in step ST46.

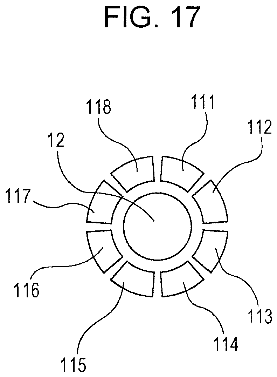

Fig. 17 is an example of a sensor composed of only the first electrodes and second electrode. The present invention does not need to have all of the first electrodes, second electrode, and third electrode, and can be also realized by the sensor as shown in Fig. 17. That is, the sensor indicated in Fig. 17 has the first electrodes 111, 112, 113, 114, 115, 116, 117, and 118 and the second electrode 12, and does not have the third electrode 13 indicated in Fig. 1.

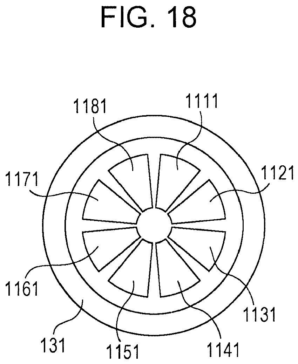

Fig. 18 is an example of a sensor composed of only the first electrodes and third electrode. The present invention does not need to have all of the first electrodes, second electrode, and third electrode, and can be also realized by the sensor as shown in Fig. 18. That is, the sensor indicated in Fig. 18 has first electrodes 1111, 1121, 1131, 1141, 1151, 1161, 1171, and 1181 and a third electrode 13, and does not have the second electrode 12 indicated in Fig. 1.

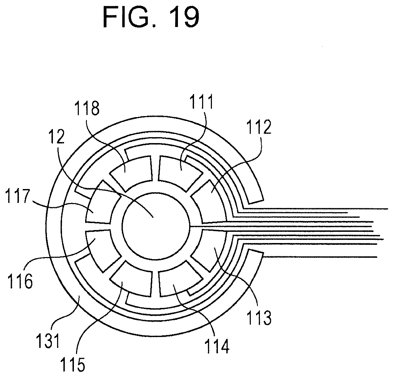

Fig. 19 is an example of a sensor in which the third electrode is not in a complete ring shape. Each electrode in the present invention does not necessarily need to be completely circular or in a complete ring shape. In the example in Fig. 19, as the third electrode 131 partially has a notch, wires from the first electrodes 111 to 118 and second electrode 12 can be led out toward the outside, enabling a single-layer sensor to be formed.

The present invention is not limited to the embodiments described above.

The scope of protection is defined solely by the claims.

Although, in the embodiments described above, the deciding unit 4 has compared the sum SUM of the capacitances CA111, CA112, CA113, CA114, CA115, CA116, CA117, CA118, CA12, and CA13 with the first threshold TH1 and second threshold TH3 in steps ST2 and ST3 indicated in Fig. 7, the sum of the capacitances CA111, CA112, CA113, CA114, CA115, CA116, CA117, and CA118 or the sum of the said sum and at least one of CA21 and CA31 may be used as the sum SUM.

Also, although, in the embodiments described above, a case has been exemplified in which both of processing, in step ST4 indicated in Fig. 7, to identify the number of manipulating bodies and their coordinates and processing, in step ST5, to identify the direction in which the manipulating body is positioned are performed, the present invention can also be applied to a case in which only processing to identify the direction in which the manipulating body is positioned is performed.

Also, although, in the embodiments described above, a case has been exemplified in which the second electrode 12 and third electrode 13 are provided, only the first electrodes 111, 112, 113, 114, 115, 116, 117, and 118 may be used.

Also, the shape of the first electrodes 111, 112, 113, 114, 115, 116, 117, and 118 may be other than a fan shape and the number of first electrodes may be other than 8 so far as the number is plural.

The method, in the present invention, of deciding a count and a coordinate is not limited to the example indicated in Fig. 8. Also, the method, in the present invention, of deciding the number of manipulating bodies on first electrodes and their coordinates is not limited to the example indicated in Fig. 9. Furthermore, the method, in the present invention, of identifying the approaching method of the manipulating body is not limited to the example in Fig. 12.

### Industrial Applicability

The present invention can be applied to a capacitive sensor.

### Reference Signs List

1 capacitive sensor
111, 112, 113, 114, 115, 116, 117, 118, 1111, 1121, 1131, 1141, 1151, 1161, 1171, 1181 first electrode
12 second electrode
13 third electrode
14 shield electrode
2, 21, 22, 23, 24 manipulating body
3 capacitance detecting unit
4 deciding unit
TH1 first threshold
TH2 second threshold
TH3 third threshold
TH4 fourth threshold
TH5 fifth threshold
TH6 sixth threshold
TH7 seventh threshold

## Claims

1. A capacitive sensor (1) comprising:
a plurality of first electrodes (111, 112, 113, 114, 115, 116, 117, 118) that are placed on the same circumference of a circle and generate a capacitance according to a distance to a manipulating body (2); and
a capacitance detecting means (3) that is configured to detect capacitances generated in the plurality of first electrodes (111, 112, 113, 114, 115, 116, 117, 118),
**characterised by**
a deciding means (4) that is configured to decide a direction in which the manipulating body (2) is positioned according to a capacitance detected for each of the plurality of first electrodes (111, 112, 113, 114, 115, 116, 117, 118) under a condition that a sum of the capacitances detected for the plurality of first electrodes (111, 112, 113, 114, 115, 116, 117, 118) is equal to or larger than a first threshold.

2. The capacitive sensor according to Claim 1, wherein
the deciding means (4) is further configured to:
identify a first electrode for which a maximum capacitance has been detected, the first electrode being one of the plurality of first electrodes (111, 112, 113, 114, 115, 116, 117, 118), and
decide, if the capacitance of the identified first electrode is equal to or larger than a second threshold, that the manipulating body (2) is positioned in a direction of the identified first electrode.

3. The capacitive sensor according to Claim 2, wherein if the capacitance of the identified first electrode is smaller than the second threshold, the deciding means (4) is configured to decide that the manipulating body is positioned in a direction perpendicular to a plane on which the plurality of first electrodes are placed.

4. The capacitive sensor according to any one of Claims 1 to 3, wherein:
a second electrode (12) is positioned at a center of the circumference enclosed by the plurality of first electrodes (111, 112, 113, 114, 115, 116, 117, 118);
a third electrode (13) in a ring shape is provided so as to enclose the plurality of first electrodes (111, 112, 113, 114, 115, 116, 117, 118); and
the deciding means (4) is further configured to decide the direction in which the manipulating body (2) is positioned according to the capacitance detected for the each of the plurality of first electrodes (111, 112, 113, 114, 115, 116, 117, 118) under a condition that a sum of the capacitances detected for the plurality of first electrodes (111, 112, 113, 114, 115, 116, 117, 118), the second electrode (12), and the third electrode (13) is equal to or larger than the first threshold.

5. The capacitive sensor according to Claim 1, wherein the deciding means (4) is further configured to decide a number of manipulating bodies that have approached according to the capacitance detected for the each of the plurality of first electrodes under a condition that the sum of the capacitances detected for the plurality of first electrodes (111, 112, 113, 114, 115, 116, 117, 118) is equal to or larger than a third threshold, which is larger than the first threshold.

6. The capacitive sensor according to Claim 5, wherein:
a second electrode (12) is positioned at a center of the circumference enclosed by the plurality of first electrodes (111, 112, 113, 114, 115, 116, 117, 118);
a third electrode (13) in a ring shape is provided so as to enclose the plurality of first electrodes (111, 112, 113, 114, 115, 116, 117, 118); and
the deciding means (4) is further configured to decide the number of manipulating bodies that have approached according to the capacitance detected for the each of the plurality of first electrodes (111, 112, 113, 114, 115, 116, 117, 118) under a condition that a sum of the capacitances detected for the plurality of first electrodes (111, 112, 113, 114, 115, 116, 117, 118), the second electrode (12), and the third electrode (13) is equal to or larger than the third threshold.

7. The capacitive sensor according to Claim 6, wherein if the deciding means (4) decides that the manipulating body (2) is positioned only on tops of the first electrodes (111, 112, 113, 114, 115, 116, 117, 118) according to the capacitances detected for the second electrode (12) and the third electrode (13), the deciding means (4) is further configured to perform processing to identify the number of manipulating bodies and positions of the manipulating bodies.

8. The capacitive sensor according to Claim 7, wherein the deciding means (4) is further configured to identify a number of first electrodes capacitances of which are equal to or larger than a fourth threshold, the first electrodes being included in the plurality of first electrodes (111, 112, 113, 114, 115, 116, 117, 118), and calculate a barycentric coordinate of the identified first electrodes.

9. The capacitive sensor according to Claim 6, wherein if the deciding means (4) decides that the manipulating body (2) is also positioned on a top of the second electrode (12) or third electrode (13) besides the first electrodes according to the capacitances detected for the second electrode (12) and third electrode (13), the deciding means (4) is further configured to decide that the number of manipulating bodies is 1.

10. The capacitive sensor according to Claim 9, wherein if the deciding means (4) decides that the manipulating body is also positioned on the top of the second electrode (12) or the third electrode (13) besides the first electrodes (111, 112, 113, 114, 115, 116, 117, 118), the deciding means is further configured to identify an electrode a capacitance of which is equal to or larger than a fifth threshold, the electrode being included in the first electrodes (111, 112, 113, 114, 115, 116, 117, 118), second electrode (12), and third electrode (13), and to calculate a barycentric coordinate according to a position of the identified electrode.

11. The capacitive sensor according to Claim 4, wherein if the sum is smaller than the third threshold, the deciding means (4) is further configured to decide the direction in which the manipulating body (2) is positioned according to the capacitance detected for the each of the plurality of first electrodes (111, 112, 113, 114, 115, 116, 117, 118).

12. The capacitive sensor according to any one of Claims 1 to 11, wherein the plurality of first electrodes (111, 112, 113, 114, 115, 116, 117, 118) have the same shape and are placed in a circumferential direction at an equal interval.

13. The capacitive sensor according to Claim 1, wherein the deciding means (4) is further configured to decide a motion of the manipulating body (2) according to a time-dependent change in the capacitance detected for the each of the plurality of first electrodes (111, 112, 113, 114, 115, 116, 117, 118).

## Patentansprüche

1. Kapazitiver Sensor (1), aufweisend:
eine Mehrzahl von ersten Elektroden (111, 112, 113, 114, 115, 116, 117, 118), die auf dem gleichen Umfang eines Kreises angeordnet sind und eine Kapazität in Abhängigkeit von einem Abstand zu einem Betätigungskörper (2) erzeugen; und
eine Kapazitätserfassungseinrichtung (3), die zum Erfassen von Kapazitäten ausgebildet ist, die in der Mehrzahl von ersten Elektroden (111, 112, 113, 114, 115, 116, 117, 118) erzeugt werden,
**gekennzeichnet durch**
eine Entscheidungseinrichtung (4), die dazu ausgebildet ist, eine Richtung, in der der Betätigungskörper (2) positioniert ist, in Abhängigkeit von einer für jede der Mehrzahl von ersten Elektroden (111, 112, 113, 114, 115, 116, 117, 118) erfassten Kapazität unter einer Bedingung festzustellen, dass eine Summe der für die Mehrzahl von ersten Elektroden (111, 112, 113, 114, 115, 116, 117, 118) erfassten Kapazitäten gleich oder größer als ein erster Schwellenwert ist.

2. Kapazitiver Sensor nach Anspruch 1,
wobei die Entscheidungseinrichtung (4) ferner dazu ausgebildet ist:
eine erste Elektrode zu identifizieren, für die eine maximale Kapazität erfasst worden ist, wobei die erste Elektrode eine von der Mehrzahl von ersten Elektroden (111, 112, 113, 114, 115, 116, 117, 118) ist, und
dann, wenn die Kapazität der identifizierten ersten Elektrode gleich oder größer als ein zweiter Schwellenwert ist, die Feststellung zu treffen, dass der Betätigungskörper (2) in einer Richtung der identifizierten ersten Elektrode positioniert ist.

3. Kapazitiver Sensor nach Anspruch 2,
wobei dann, wenn die Kapazität der identifizierten ersten Elektrode kleiner als der zweite Schwellenwert ist, die Entscheidungseinrichtung (4) dazu ausgebildet ist, die Feststellung zu treffen, dass der Betätigungskörper in einer Richtung rechtwinklig zu einer Ebene positioniert ist, in der die Mehrzahl von ersten Elektroden angeordnet ist.

4. Kapazitiver Sensor nach einem der Ansprüche 1 bis 3, wobei:
eine zweite Elektrode (12) im Zentrum des Umfangs positioniert ist, der von der Mehrzahl von ersten Elektroden (111, 112, 113, 114, 115, 116, 117, 118) umschlossen ist;
eine dritte Elektrode (13) in Ringform derart vorgesehen ist, dass sie die Mehrzahl von ersten Elektroden (111, 112, 113, 114, 115, 116, 117, 118) umschließt; und
die Entscheidungseinrichtung (4) ferner dazu ausgebildet ist, die Richtung, in der der Betätigungskörper (2) positioniert ist, in Abhängigkeit von der für jede der Mehrzahl von ersten Elektroden (111, 112, 113, 114, 115, 116, 117, 118) erfassten Kapazität unter einer Bedingung festzustellen, dass eine Summe der für die Mehrzahl von ersten Elektroden (111, 112, 113, 114, 115, 116, 117, 118), die zweite Elektrode (12) und die dritte Elektrode (13) erfassten Kapazitäten gleich oder größer als der erste Schwellenwert ist.

5. Kapazitiver Sensor nach Anspruch 1,
wobei die Entscheidungseinrichtung (4) ferner dazu ausgebildet ist, eine Feststellung hinsichtlich einer Anzahl von Betätigungskörpern, die sich angenähert haben, in Abhängigkeit von der für jede der Mehrzahl von ersten Elektroden erfassten Kapazität unter einer Bedingung zu treffen, dass die Summe der für die Mehrzahl von ersten Elektroden (111, 112, 113, 114, 115, 116, 117, 118) erfassten Kapazitäten gleich oder größer als ein dritter Schwellenwert ist, der größer als der erste Schwellenwert ist.

6. Kapazitiver Sensor nach Anspruch 5, wobei:
eine zweite Elektrode (12) im Zentrum des Umfangs positioniert ist, der von der Mehrzahl von ersten Elektroden (111, 112, 113, 114, 115, 116, 117, 118) umschlossen ist;
eine dritte Elektrode (13) in Ringform derart vorgesehen ist, dass sie die Mehrzahl von ersten Elektroden (111, 112, 113, 114, 115, 116, 117, 118) umschließt; und
die Entscheidungseinrichtung (4) ferner dazu ausgebildet ist, die Feststellung hinsichtlich der Anzahl von Betätigungskörpern, die sich angenähert haben, in Abhängigkeit von der für jede der Mehrzahl von ersten Elektroden (111, 112, 113, 114, 115, 116, 117, 118) erfassten Kapazität unter einer Bedingung zu treffen, dass eine Summe der für die Mehrzahl von ersten Elektroden (111, 112, 113, 114, 115, 116, 117, 118), die zweite Elektrode (12) und die dritte Elektrode (13) erfassten Kapazitäten gleich oder größer als der dritte Schwellenwert ist.

7. Kapazitiver Sensor nach Anspruch 6,
wobei dann, wenn die Entscheidungseinrichtung (4) in Abhängigkeit von den für die zweite Elektrode (12) und die dritte Elektrode (13) erfassten Kapazitäten die Feststellung trifft, dass der Betätigungskörper (2) nur auf Oberseiten der ersten Elektroden (111, 112, 113, 114, 115, 116, 117, 118) positioniert ist, die Entscheidungseinrichtung (4) ferner dazu ausgebildet ist, eine Verarbeitung zur Identifizierung der Anzahl von Betätigungskörpern und der Positionen der Betätigungskörper durchzuführen.

8. Kapazitiver Sensor nach Anspruch 7,
wobei die Entscheidungseinrichtung (4) ferner dazu ausgebildet ist, eine Anzahl von ersten Elektroden zu identifizieren, deren Kapazitäten gleich oder größer als ein vierter Schwellenwert sind, wobei die ersten Elektroden in der Mehrzahl von ersten Elektroden (111, 112, 113, 114, 115, 116, 117, 118) enthalten sind, sowie eine baryzentrische Koordinate der identifizierten ersten Elektroden zu berechnen.

9. Kapazitiver Sensor nach Anspruch 6,
wobei dann, wenn die Entscheidungseinrichtung (4) in Abhängigkeit von den für die zweite Elektrode (12) und die dritte Elektrode (13) erfassten Kapazitäten die Feststellung trifft, dass der Betätigungskörper (2) neben den ersten Elektroden auch auf einer Oberseite der zweiten Elektrode (12) oder der dritten Elektrode (13) positioniert ist, die Entscheidungseinrichtung (4) ferner dazu ausgebildet ist, die Feststellung zu treffen, dass die Anzahl der Betätigungskörper 1 ist.

10. Kapazitiver Sensor nach Anspruch 9,
wobei dann, wenn die Entscheidungseinrichtung (4) die Feststellung trifft, dass der Betätigungskörper neben den ersten Elektroden (111, 112, 113, 114, 115, 116, 117, 118) auch auf der Oberseite der zweiten Elektrode (12) oder der dritten Elektrode (13) positioniert ist, die Entscheidungseinrichtung ferner dazu ausgebildet ist, eine Elektrode zu identifizieren, deren Kapazität gleich oder größer als ein fünfter Schwellenwert ist, wobei die Elektrode in den ersten Elektroden (111, 112, 113, 114, 115, 116, 117, 118), der zweiten Elektrode (13) und der dritten Elektrode (13) enthalten ist, sowie eine baryzentrische Koordinate in Abhängigkeit von einer Position der identifizierten Elektrode zu berechnen.

11. Kapazitiver Sensor nach Anspruch 4,
wobei dann, wenn die Summe kleiner ist als der dritte Schwellenwert, die Entscheidungseinrichtung (4) ferner dazu ausgebildet ist, die Richtung, in der der Betätigungskörper (2) positioniert ist, in Abhängigkeit von der für jede der Mehrzahl von ersten Elektroden (111, 112, 113, 114, 115, 116, 117, 118) erfassten Kapazität festzustellen.

12. Kapazitiver Sensor nach einem der Ansprüche 1 bis 11,
wobei die Mehrzahl von ersten Elektroden (111, 112, 113, 114, 115, 116, 117, 118) die gleiche Form aufweisen und in Umfangsrichtung in gleichen Intervallen angeordnet sind.

13. Kapazitiver Sensor nach Anspruch 1,
wobei die Entscheidungseinrichtung (4) ferner dazu ausgebildet ist, eine Bewegung des Betätigungskörpers (2) in Abhängigkeit von einer zeitabhängigen Änderung der für jede der Mehrzahl von ersten Elektroden (111, 112, 113, 114, 115, 116, 117, 118) erfassten Kapazität festzustellen.

## Revendications

1. Capteur capacitif (1) qui comprend :
une pluralité de premières électrodes (111, 112, 113, 114, 115, 116, 117, 118) qui sont placées sur la même circonférence d'un cercle et qui génèrent une capacité en fonction d'une distance par rapport à un corps de manipulation (2) ; et
un moyen de détection de capacité (3) qui est configuré pour détecter les capacités qui sont générées dans la pluralité des premières électrodes (111, 112, 113, 114, 115, 116, 117, 118) ;
**caractérisé par** :
un moyen de prise de décision (4) qui est configuré pour décider d'une direction dans laquelle le corps de manipulation (2) est positionné en fonction d'une capacité qui a été détectée pour chacune de la pluralité des premières électrodes (111, 112, 113, 114, 115, 116, 117, 118) à une condition telle qu'une somme des capacités qui ont été détectées pour de la pluralité des premières électrodes (111, 112, 113, 114, 115, 116, 117, 118) est égale ou est supérieure à un premier seuil.

2. Capteur capacitif selon la revendication 1, dans lequel :
le moyen de prise de décision (4) est en outre configuré pour :
identifier une première électrode pour laquelle une capacité maximale a été détectée, la première électrode étant l'une parmi la pluralité des premières électrodes (111, 112, 113, 114, 115, 116, 117, 118) ; et
décider, lorsque la capacité de la première électrode qui a été identifiée est égale ou est supérieure à un deuxième seuil, le corps de manipulation (2) est positionné dans une direction de la première électrode qui a été identifiée.

3. Capteur capacitif selon la revendication 2, dans lequel, lorsque la capacité de la première électrode identifiée est inférieure au deuxième seuil, le moyen de prise de décision (4) est configuré pour décider que le corps de manipulation est positionné dans une direction qui est perpendiculaire à un plan dans lequel sont placées la pluralité des premières électrodes.

4. Capteur capacitif selon l'une quelconque des revendications 1 à 3, dans lequel :
une deuxième électrode (12) est positionnée à un centre de la circonférence qui est délimitée par de la pluralité des premières électrodes (111, 112, 113, 114, 115, 116, 117, 118) ;
une troisième électrode (13) présentant une configuration de forme annulaire est prévue de façon à entourer la pluralité des premières électrodes (111, 112, 113, 114, 115, 116, 117, 118) ; et
le moyen de prise de décision (4) est en outre configuré pour décider de la direction dans laquelle le corps de manipulation (2) est positionné en fonction de la capacité qui a été détectée pour chacune de la pluralité des premières électrodes (111, 112, 113, 114, 115, 116, 117, 118) à une condition telle qu'une somme des capacités qui ont été détectées pour la pluralité des premières électrodes (111, 112, 113, 114, 115, 116, 117, 118), pour ladite deuxième électrode (12) et pour ladite troisième électrode (13) est égale ou est supérieure au premier seuil.

5. Capteur capacitif selon la revendication 1, dans lequel le moyen de prise de décision (4) est en outre configuré pour décider d'un nombre de corps de manipulation que l'on obtient par approximation en fonction de la capacité qui a été détectée pour chacune de la pluralité des premières électrodes à une condition telle que la somme des capacités qui ont été détectées pour la pluralité des premières électrodes (111, 112, 113, 114, 115, 116, 117, 118) est égale ou est supérieure à un troisième seuil, qui est supérieur au premier seuil.

6. Capteur capacitif selon la revendication 5, dans lequel :
une deuxième électrode (12) est positionnée à un centre de la circonférence qui est délimitée par la pluralité des premières électrodes (111, 112, 113, 114, 115, 116, 117, 118) ;
une troisième électrode (13) présentant une configuration de forme annulaire est prévue d'une manière telle qu'elle entoure la pluralité des premières électrodes (111, 112, 113, 114, 115, 116, 117, 118) ; et
le moyen de prise de décision (4) est en outre configuré pour décider du nombre de corps de manipulation que l'on obtient par approximation en fonction de la capacité qui a été détectée pour chacune de la pluralité des premières électrodes (111, 112, 113, 114, 115, 116, 117, 118) à une condition telle qu'une somme des capacités qui ont été détectées pour la pluralité des premières électrodes (111, 112, 113, 114, 115, 116, 117, 118), pour la deuxième électrode (12) et pour la troisième électrode (13) est égale ou est supérieure au troisième seuil.

7. Capteur capacitif selon la revendication 6, dans lequel, lorsque le moyen de prise de décision (4) décide que le corps de manipulation (2) est positionné uniquement sur des sommets des premières électrodes (111, 112, 113, 114, 115, 116, 117, 118) en fonction des capacités qui ont été détectées pour la deuxième électrode (12) et pour la troisième électrode (13), le moyen de prise de décision (4) est en outre configuré pour mettre en œuvre un traitement qui est destiné à identifier le nombre de corps de manipulation et les positions des corps de manipulation.

8. Capteur capacitif selon la revendication 7, dans lequel le moyen de prise de décision (4) est en outre configuré pour identifier un nombre de premières électrodes dont les capacités sont égales ou sont supérieures à un quatrième seuil, les premières électrodes étant incluses dans la pluralité des premières électrodes (111, 112, 113, 114, 115, 116, 117, 118); et pour calculer une coordonnée barycentrique des premières électrodes qui ont été identifiées.

9. Capteur capacitif selon la revendication 6, dans lequel, lorsque le moyen de prise de décision (4) décide que le corps de manipulation (2) est également positionné sur un sommet de la deuxième électrode (12) ou de la troisième électrode (13), en plus de celui des premières électrodes, en fonction des capacités qui ont été détectées pour la deuxième électrode (12) et pour la troisième électrode (13), le moyen de prise de décision (4) est en outre configuré pour décider que le nombre des corps de manipulation est égal à 1.

10. Capteur capacitif selon la revendication 9, dans lequel, lorsque le moyen de prise de décision (4) décide que le corps de manipulation (2) est également positionné sur le sommet de la deuxième électrode (12) ou de la troisième électrode (13), en plus de celui des premières électrodes (111, 112, 113, 114, 115, 116, 117, 118), le moyen de prise de décision (4) est en outre configuré pour identifier une électrode dont la capacité est égale ou supérieure à un cinquième seuil, l'électrode étant incluse dans les premières électrodes (111, 112, 113, 114, 115, 116, 117, 118), dans la deuxième électrode (12) et dans la troisième électrode (13) ; et pour calculer une coordonnée barycentrique en fonction d'une position de l'électrode qui a été identifiée.

11. Capteur capacitif selon la revendication 4, dans lequel, lorsque la somme est inférieure au troisième seuil, le moyen de prise de décision (4) est en outre configuré pour décider de la direction dans laquelle le corps de manipulation (2) est positionné en fonction de la capacité qui a été détectée pour chacune de la pluralité des premières électrodes (111, 112, 113, 114, 115, 116, 117, 118).

12. Capteur capacitif selon l'une quelconque des revendications 1 à 11, dans lequel la pluralité des premières électrodes (111, 112, 113, 114, 115, 116, 117, 118) présentent la même configuration et sont placées dans une direction circonférentielle à un intervalle égal.

13. Capteur capacitif selon la revendication 1, dans lequel le moyen de prise de décision (4) est en outre configuré pour décider d'un mouvement du corps de manipulation (2) en fonction d'un changement dépendant du temps en ce qui concerne la capacité qui a été détectée pour chacune de la pluralité des premières électrodes (111, 112, 113, 114, 115, 116, 117, 118).
